# EUROPEAN PATENT APPLICATION

(11) **EP 4 246 809 A1**
(43) Date of publication of application: **20.09.2023**
(21) Application number: 21894022.9
(22) Date of filing: 19.11.2021
(51) Int. Cl.: H03K 17/955

(54) **INPUT DEVICE, INPUT METHOD AND KEYBOARD**

(30) Priority: 20.11.2020 CN 202011312892; 20.11.2020 CN 202022722077 U
(71) Applicant: Shenzhen Lichi Innovation and Technology Co. Ltd., Shenzhen, Guangdong 518172 (CN)
(72) Inventor: HUANG, Jianan, Shenzhen, Guangdong 518172 (CN); LI, Kan, Shenzhen, Guangdong 518172 (CN); YE, Hongbing, Shenzhen, Guangdong 518172 (CN); YAN, Weicai, Shenzhen, Guangdong 518172 (CN); LIU, Guilin, Shenzhen, Guangdong 518172 (CN)
(74) Representative: Proi World Intellectual Property GmbH
(86) International application number: PCT/CN2021/131776
(87) International publication number: WO 2022/105875

(57) **Abstract**

The application provides an input device. The input device comprises a key module, a capacitance detection module and a control module, wherein the key module receives a physical pressing signal and accordingly feeds back a capacitance change signal; the capacitance detection module receives the capacitance change signal from the key module and judges a working state of the key module; the control module receives a judgment result from the capacitance detection module and correspondingly generates an input signal. The key module comprises a key switch and a capacitor circuit which are arranged in series. The key module accordingly adjusts the change of the capacitance value of the key module in response to the external physical pressing signal. With the key module of the present application, the sensitivity of judging the working state of the key module is improved by connecting the capacitor circuit in series. Therefore, the requirement on assembly precision of the key switch is reduced, and the product installation difficulty is reduced. Meanwhile, the present application also provides an input method and a keyboard adopting the input device.

## Description

### FIELD OF THE INVENTION

The present application relates to a key switch, in particular to an input device, an input method and a keyboard for a capacitive mechanical key as an input system.

### BACKGROUND OF THE INVENTION

With the development of modem electronic technology, electronic products have gradually penetrated into people's lives. All kinds of electronic products, such as telephones, mobile phones, notebook computers and remote controllers, accompany people's daily lives.

Input systems of the above electronic products play a particularly important role. At present, the input systems widely used in the industry mainly include mechanical keyboards and capacitive keyboards.

A key module of the mechanical keyboard of the related art is usually based on a contact principle, which relies on contact conduction of two electrode pieces as a key switch, so that a main control chip can capture a touching or pressing of the key, judge a working state of the key module, and then generate an input signal. However, the electrode pieces used for conduction are prone to be oxidated when exposed to air for a long time, and mutual contact between the two electrode pieces will also cause abrasion to the electrode pieces during each pressing process. Therefore, the abrasion and oxidation may cause bad contact of the electrode pieces during pressing. When the electrode pieces of the key are abrased or oxidized, after the key is pressed, the main control chip can't recognize it, and the pressing is usually judged as an invalid input, despite the fact that the key has been pressed, which degrade the user experience. In this case, the whole keyboard or only a single key have to be replaced.

In the capacitive keyboard of the related art, the capacitive keyboard comprises a capacitor composed of two electrode pieces which are relatively spaced apart and an insulator disposed between the two electrode pieces. The working principle of the capacitive keyboard is that an insulating layer is additionally arranged between two electrode pieces, and the two electrode pieces are coupled to form a capacitor structure. When the key is pressed, the spacing between the two electrode pieces is changed, such as the two electrode pieces are closer to each other or further away from each other, so that the capacitance value of the capacitor structure formed by the two electrode pieces becomes larger or smaller. Then, a capacitance detection module is provided, which detects the change amount of the capacitance of the capacitor structure using a capacitance detection principle to judge the working state of the key, so as to confirm whether there is a valid input.

However, in the capacitive key of the related art, the insulating layer needs to be additionally arranged between the two electrode pieces. In order to ensure a large change amount of the capacitance and consistency, the insulating layer needs to be very thin with a small tolerance, which requires additional high-precision processing procedures and thus increases its cost. Moreover, due to mistakes in an assembly process or an excessive pressing force in use, the insulating layer may fall off, which will lead to a short-circuit failure of the capacitive key, and even lead to an abnormal function of the whole keyboard system. Furthermore, due to poor consistency between the electrode pieces and the insulating layer processed by different procedures and processing apparatuses, a judgment error of the working state of the key is also easily caused.

### SUMMARY OF THE INVENTION

In order to solve the technical problem in the related art that an input device of a capacitive mechanical key cannot recognize whether a key is pressed or not due to bad contact of electrode pieces, and the technical problems of abnormal function and poor consistency of a capacitive keyboard, the invention provide an input device and an input method which can accurately determine whether the key is pressed or not under the condition of bad contact of the electrode pieces, and also has good consistency and reliability. Meanwhile, the invention also provides a keyboard adopting the input device.

The present application provides an input device, which comprises a key module, a capacitance detection module and a control module, wherein the key module receives a physical pressing signal and accordingly feeds back a capacitance change signal; the capacitance detection module receives the capacitance change signal from the key module and judges a working state of the key module; the control module receives a judgment result from the capacitance detection module and correspondingly generates an input signal. The key module comprises a key switch and a capacitor circuit which are arranged in series. The key module accordingly adjusts a change of a capacitance value of the key module in response to the external physical pressing signal.

In a preferred embodiment of the key module provided in the present application, the capacitor circuit comprises a fixed capacitor or a plurality of fixed capacitors which are connected in series or parallel to output a capacitance value. The capacitor circuit cooperates with the key switch to output a capacitance change signal.

In a preferred embodiment of the key module provided in the present application, the capacitor circuit includes multiple branches, each of the branches including at least one branch switch. The branch switch is turned on or off, so that the capacitor circuit outputs a corresponding set capacitance value, and the change of the capacitance value of the key module is adjusted.

In a preferred embodiment of the key module provided in the present application, the key switch is a contact switch, and the key module further comprises a pressing body. The pressing body moves down or up to switch the contact switch between an on-state and an off-state.

In a preferred embodiment of the key module provided in the present application, the key switch includes two conductive terminals, and the pressing body moves down or up so that the two conductive terminals can be in contact conduction with each other or separately disconnected.

In a preferred embodiment of the key module provided by the application, the key switch is an adjustable capacitor, and the adjustable capacitor is correspondingly arranged in series with the capacitor circuit.

In a preferred embodiment of the key module provided by the application, the adjustable capacitor comprises a first electrode piece and a second electrode piece which are relatively coupled at an interval, wherein the first electrode piece and the second electrode piece are driven by a physical pressing signal to adjust a capacitance value of the key module.

In a preferred embodiment of the key module provided in the present application, an insulating layer is arranged between the first electrode piece and the second electrode piece.

An input method comprises the following steps:
providing a pressing body, which can be physically pressed by an external force, the pressing body responding to the external physical pressing signal;
providing a key switch which is triggered to switch its working state between an on-state and an off-state in response to the physical pressing signal from the pressing body;
providing a capacitor circuit arranged in series with that key switch, wherein a change magnitude of the capacitance of the key module is adjusted according to the working state of the key switch to generate a capacitance change signal;
providing a capacitance detection module, which can judge whether the working state of the key module is active or not according to the capacitance change signal of the key module;
providing a control module, which correspondingly generates an input signal according to the active state of the key module.

A keyboard comprises a plurality of input devices and a control panel, wherein the input devices are arranged on the control panel in an array, and the input devices comprise a key module, a capacitance detection module and a control module. The key module receives a physical pressing signal and accordingly feeds back a capacitance change signal. The capacitance detection module receives the capacitance change signal from the key module and judges a working state of the key module, The control module receives a judgment result from the capacitance detection module and correspondingly generates an input signal. The key module comprises a key switch and a capacitor circuit which are arranged in series. The key module accordingly adjusts a change of a capacitance value of the key module in response to the external physical pressing signal.

Compared with the related art, the invention can dispose the key switch in the input device, and additionally arrange the capacitor circuit in series in the key switch, so that whether the input device is pressed or not can be recognized even under the condition of bad contact of the electrodes of the key switch, thus avoiding the situation that the user has to replace the input device because an input signal cannot be fed back due to bad contact of the electrodes of the key switch, thereby saving the user's cost and improving the user experience.

On the other hand, because it is less difficult to detect the capacitance change of the input device, it is easy to judge a working state of the input device, thereby reducing the installation difficulty of the input device, improving the input accuracy and reducing misoperation.

Furthermore, that product consistency requirement of the input device is reduced. The working state of the input device can be easily judged, and the product reliability is improved.

### BRIEF DESCRIPTION OF THE DRAWINGS

In order to explain the technical solutions in the embodiments of the present application more clearly, the following will briefly introduce the drawings needed in the description of the embodiments. Obviously, the drawings in the following description are only some of the embodiments of the present application. For those of ordinarily skilled in the art, other drawings can be obtained according to these drawings without any creative effort, in which:
Fig. 1 is a schematic perspective structural view of an assembled key module disclosed in a first embodiment of the present application;
Fig. 2 is a schematic exploded perspective view of the key module shown in Fig. 1;
Figs. 3a and 3b are side sectional views of the key module shown in Fig. 1 in an on-state and an off-state, respectively;
Figs. 4a and 4b are equivalent circuit diagrams corresponding to a key switch shown in Figs. 3a and 3b;
Fig. 5 is a schematic exploded perspective view of a key module disclosed in a second embodiment of the present application;
Figs. 6a and 6b are side sectional views of the key module shown in Fig. 5 in different working states, respectively;
Fig. 7 is an equivalent circuit diagram of a variable capacitor and a capacitor circuit connected in series shown in Fig. 5;
Figs. 8a and 8b are side sectional views of a key module disclosed in a third embodiment of the present application in different working states, respectively;
Fig. 9 is a block diagram of an input device of the present application;
Fig. 10 is a schematic perspective structural view of a keyboard of the present application;
Figs. 11a and 11b are circuit structure diagrams corresponding to a circuit board of the keyboard shown in Fig. 10.

### DETAILED DESCRIPTION OF THE INVENTION

The technical solutions in the embodiments of the present application will be clearly and completely described below with reference to the drawings in the embodiments of the present application. Obviously, the described embodiments are only part of the embodiments of the present application, but not all of them. Based on the embodiments in the present application, all other embodiments obtained by those of ordinarily skilled in the art without creative efforts are within the scope of protection in the present application.

### A first embodiment

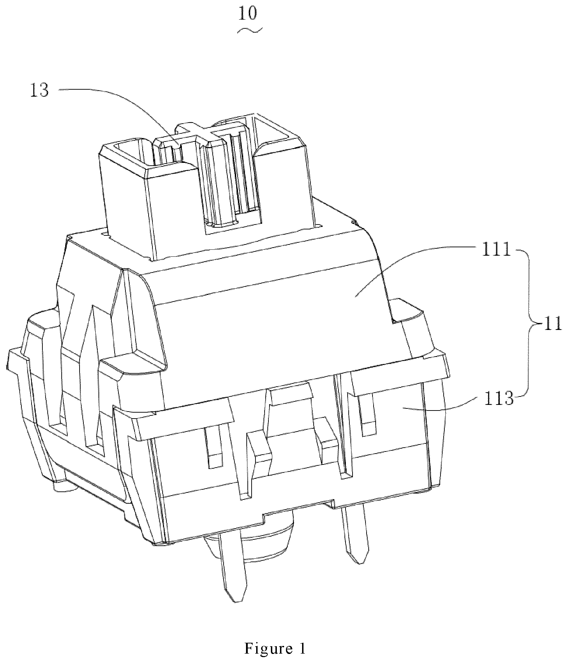

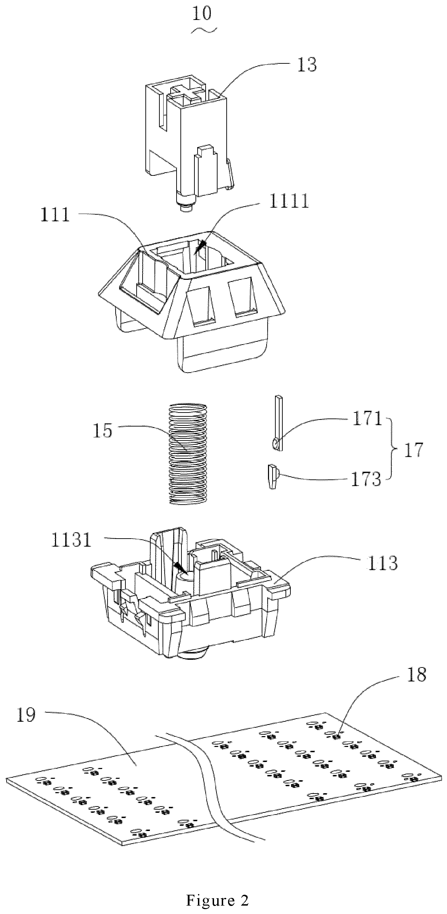

Please refer to Fig. 1 and Fig. 2, in which Fig. 1 is a schematic perspective structural view of an assembled key module disclosed in the first embodiment of the present application, and Fig. 2 is a schematic exploded perspective view of the key module shown in Fig. 1. The key module 10 includes a housing 11, a pressing body 13, an elastic body 15, a key switch 17, a capacitor circuit 18 and a circuit board 19.

The housing 11 includes an upper cover 111 and a lower cover 113. The upper cover 111 includes a hollow through hole 1111. The lower cover 113 includes a lead post 1131. The lead post 1131 is disposed corresponding to the hollow through hole 1111 of the upper cover 111. The upper cover 111 cooperates with the lower cover 113 through a snap-fit structure to enclose an accommodating space to accommodate the pressing body 13, the elastic body 15 and the key switch 17 therein. The circuit board 19 is disposed under an outside surface of the lower cover 113.

One end of the pressing body 13 penetrates through the hollow through hole 1111 of the upper cover 111, and the other end is sleeved in the lead post 1131. The elastic body 15 is disposed between the lower cover 113 and the pressing body 13. The pressing body 13 is pressed by an external physical force, and moves down along the lead post 1131 toward the lower cover 113, thereby in turn compressing the elastic body 15.

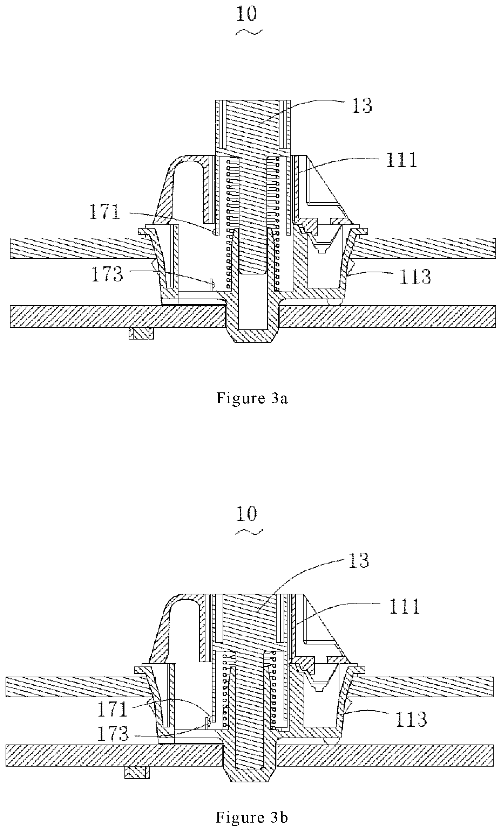

The key switch 17 includes two conductive terminals 171, 173. The conductive terminal 171 is arranged on the pressing body 13, and the conductive terminal 173 is arranged on the lower cover 113. Under the action of the pressing body 13, the conductive terminals 171, 173 can be in contact conduction with each other or separately disconnected. When the conductive terminal 171 and the conductive terminal 173 contact each other, the key switch 17 is turned on; otherwise, the key switch 17 is turned off, as shown in Figs. 3a and 3b respectively.

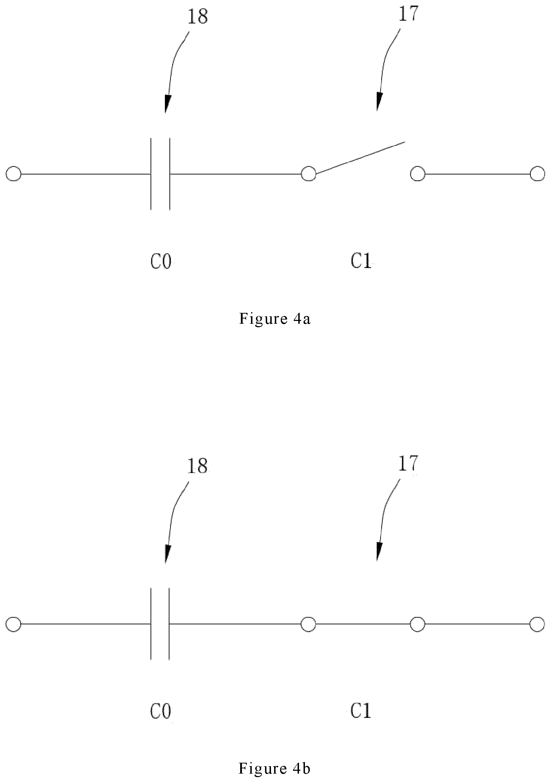

The capacitor circuit 18 is arranged on the circuit board 19, and the capacitor circuit 18 is connected in series with the key switch 17, as shown in Figs. 4a and 4b. In this embodiment, the capacitor circuit 18 is a fixed capacitor. As a further improvement to this embodiment, the capacitor circuit 18 may also include a plurality of fixed capacitors, which are connected in series or parallel to form multiple branches, each of the branches including at least one branch switch. By turning on or off the branch switch, the capacitor circuit 18 can output a corresponding set capacitance value, and a change of a capacitance value of the key module 10 is adjusted.

When the key module 10 is in operation, an external force is first applied to the pressing body 13, and the pressing body 13 receives the physical pressing signal, and moves down along a guiding direction of the lead post 1131 until the key switch 17 contacts and turns on, that is, the key switch 17 is triggered to be in an on-state in response to the external physical pressing signal. When the external pressure is removed, the pressing body 13 moves upward away from the lower cover 113 under the reaction of the elastic body 15, so that the conductive terminals 171 and 173 are separately disconnected from each other, and the key switch 17 is in an off-state, that is, the key switch 17 is triggered to be in the off-state in response to the external physical pressing signal.

When the key switch 17 is turned off, it forms an open circuit. At this time, the capacitance value of the key switch 17 is set equal to a smaller relative capacitance value C1 existing between the conductive terminal 171 and the conductive terminal 173. If the capacitance value of the capacitor circuit 18 is set to C0, which is much larger than C1, then when the key switch 17 is turned off, the capacitance value of the branch formed by the key switch 17 and the capacitor circuit 18 connected in series is C=C1^{∗}C0/(C1+C0). In view of the small value of C0, accordingly, when the key switch 17 is turned off, the total capacitance value of the branch formed by the key switch 17 and the capacitance circuit 18 connected in series is small.

When the key switch 17 contacts, a short circuit is formed. At this time, the capacitance value C of the branch formed by the key switch 17 and the capacitor circuit 18 connected in series is: C=C0. When the key switch 17 is switched between the off-state and the on-state, the C1 value is small, and the C0 value is much larger than the C1 value, so the capacitance value of the branch formed by the key switch 17 and the capacitor circuit 18 connected in series changes greatly. Therefore, the way judging the working state of the key switch 17 according to the change magnitude of the capacitance value of the branch formed by the key switch 17 and the capacitor circuit 18 connected in series can also be used as a basis for judging whether the pressing body 13 is pressed.

To sum up, based on whether an external pressure is applied or not, the pressing body 13 moves up or down to and fro under the guidance of the lead post 1131, and the capacitance value of the branch formed by the key switch 17 and the capacitor circuit 18 connected in series changes greatly. According to the change of the capacitance value, it can be judged whether the working state of the key switch 17 is the on-state or the off-state, and this can also be used as a basis for judging whether the pressing body 13 is pressed. That is, based on whether an external force is applied or not, the conductive terminals 171 and 173 of the key switch 17 are switched between mutual contact or separation, and accordingly, the working state of the key switch 17 is adjusted to be switched between the on-state and the off-state. When the key switch 17 is in the on-state, the key module 10 is activated, which is regarded as a valid input. When the key switch 17 is in the off-state, the key module 10 is not activated, which is regarded as an invalid input.

In particular, if the key switch 17 is in bad contact, that is, when the conductive terminals 171 and 173 are very close to each other, the relative capacitance C1 between the conductive terminals 171 and 173 is obviously increased compared with that when the key switch 17 is turned off. Because the capacitance value C of the branch formed by the key switch 17 and the capacitor circuit 18 connected in series is: C=C1^{∗}C0/(C1+C0), accordingly, the C is also changed greatly. In this embodiment, the working state of the key switch 17 and whether the pressing body 13 is pressed or not are judged according to the change of the capacitance value C. Therefore, even if the key switch 17 is in bad contact, the key module 10 will be activated because of the large change magnitude of the capacitance value C, which is regarded as a valid input.

### A second embodiment

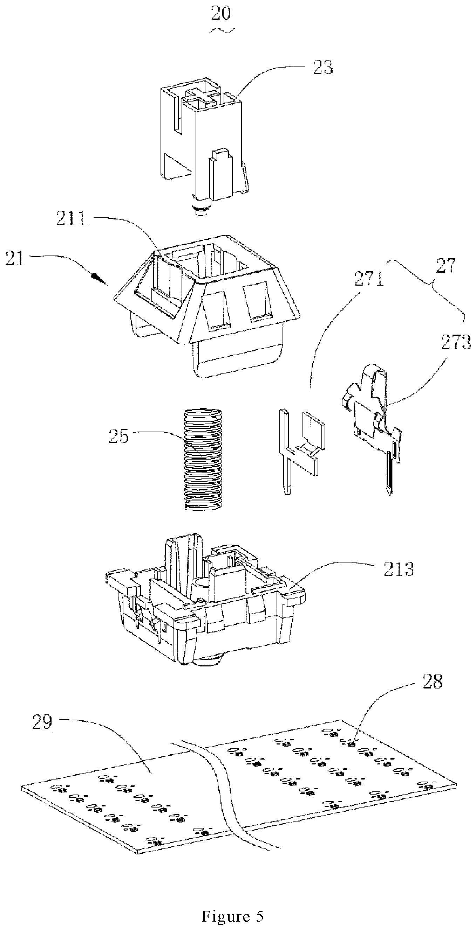

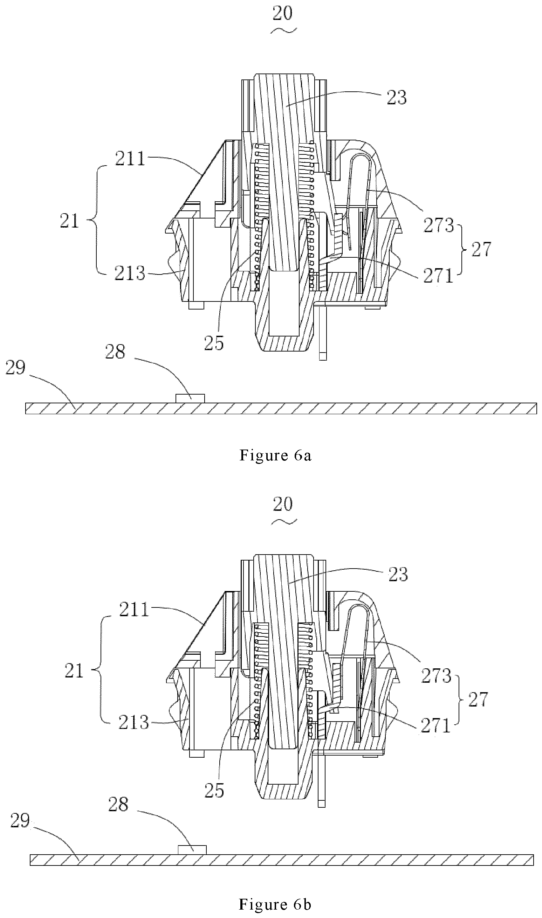

Please also refer to Figs. 5, 6a and 6b, which are schematic exploded perspective views of a key module disclosed in the second embodiment of the present application. Figs. 6a and 6b are side sectional views of the key module in different working states, in which Fig. 6a shows that the pressing body is not pressed, and the key module is not activated, while Fig. 6b shows that the key module is activated after the pressing body is pressed. The key module 20 includes a housing 21, a pressing body 23, an elastic body 25, a variable capacitor 27, a capacitor circuit 28 and a circuit board 29.

The housing 21 includes an upper cover 211 and a lower cover 213. The upper cover 211 and the lower cover 213 cooperate to enclose an accommodating space to accommodate the pressing body 23, the elastic body 25, the variable capacitor 27 and the capacitor circuit 28 therein. The circuit board 29 is disposed under the lower side of the lower cover 213.

The pressing body 23 elastically abuts against the elastic body 25. The elastic body 25 is disposed between the pressing body 23 and the lower cover 213.

The variable capacitor 27 includes a first electrode piece 271 and a second electrode piece 273 which are coupled at a relative spacing. The pressing body 23 transmits a physical pressing signal to the variable capacitor 27 under the action of external physical pressing. The capacitance value of the variable capacitor 27 changes by changing a relative area and a distance between the first electrode piece 271 and the second electrode piece 273. When an external force is applied to the pressing body 23 and the pressing body 23 in turn presses and triggers the variable capacitor 27, the capacitance value of the variable capacitor 27 is C2. When the external force is removed, the capacitance value of the variable capacitor 27 is C3. Based on whether the external force is applied to press the pressing body 23 or not, the capacitance value of the variable capacitor 27 changes between C2 and C3.

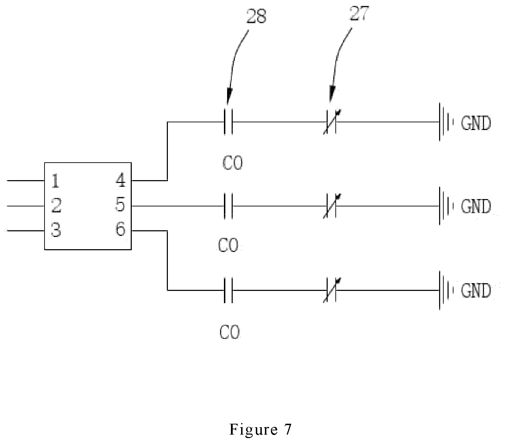

The capacitor circuit 28 is arranged on the circuit board 29. The capacitor circuit 28 is connected in series with the variable capacitor 27. Its equivalent circuit diagram is shown in Figure 7. In this embodiment, the capacitor circuit 28 is a fixed capacitor. As a further improvement to this embodiment, the capacitor circuit 28 may also include a plurality of fixed capacitors, which are connected in series or parallel to form multiple branches, each of the branches including at least one branch switch. By turning on or off the branch switch, the capacitor circuit 28 can output a corresponding set capacitance value, and the change of the capacitance value of the key module 20 can be adjusted.

If the capacitance value of the capacitor circuit 28 is set to C0, when the pressing body 23 is pressed, the capacitance value of the branch formed by the variable capacitor 27 and the capacitor circuit 28 connected in series is C=C2 ^{∗} C0/(C2+C0). When the external force is removed and the pressing body 23 does not trigger the variable capacitor 27, the capacitance value of the variable capacitor 27 is C3, and the capacitance value of the branch formed by the variable capacitor 27 and the capacitor circuit 28 connected in series is C=C3^{∗}C0/(C3+C0).

In this embodiment, the capacitor formed by the first electrode piece 271 and the second electrode piece 273 of the variable capacitor 27 is in a triggered state or a non-triggered state, respectively. Accordingly, the capacitance value of the variable capacitor 27 is switched between C2 and C3, so that the capacitance value of the branch formed by the variable capacitor 27 and the capacitor circuit 28 connected in series changes greatly. The working state of the key module 20 is judged based on the change of the capacitance value. Specifically, when the pressing body 23 is pressed, the capacitance value of the branch formed by the variable capacitance 27 and the capacitor circuit 28 connected in series is C=C2^{∗}C0/(C2+C0), and the key module 20 is in a triggered state. When the pressing body 23 is not pressed or the pressure is released, the capacitance value of the branch formed by the variable capacitor 27 and the capacitor circuit 28 connected in series is C=C3^{∗}C0/(C3+C0), and the key module 20 is in a non-triggered state.

It should be particularly noted that, if the first electrode piece 271 and the second electrode piece 273 are in contact with each other under the pressure of the pressing body 23, the variable capacitor 27 is short-circuited, and thus does not output a capacitance value. Therefore, the capacitance value of a branch formed by the variable capacitor 27 and the capacitor circuit 28 connected in series is C=C0, and the key module 20 is also in a triggered state.

### A third embodiment

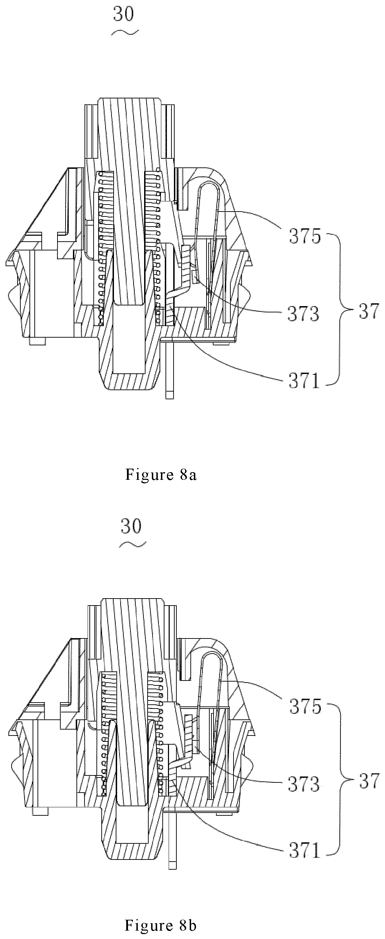

Please refer to Figs. 8a and 8b, which are side sectional views of a key module disclosed in the third embodiment of the present application in different working states respectively. The key module 30 of this embodiment is basically the same as the key module 20 disclosed in the previous embodiment, except that the variable capacitor 37 includes a first electrode piece 371, an insulator 373 and a second electrode piece 375, wherein the insulating layer 373 is disposed between the first electrode piece 371 and the second electrode piece 375.

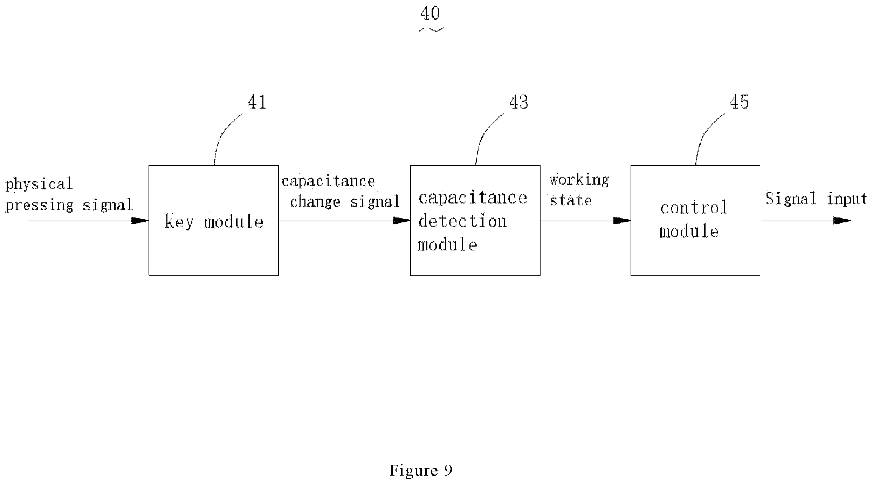

Please refer to Fig. 9, which is a structural block diagram of an input device of the present application. The input device 40 includes a key module 41, a capacitance detection module 43 and a control module 45.

The key module 41 receives a physical pressing signal and accordingly feeds back a capacitance change signal.

The capacitance detection module 43 detects the capacitance change signal of the key module 41, and judges a working state of the key module 41 according to the capacitance change result. Specifically, the key module 41 includes an active state and an inactive state. When the key module 41 is pressed, it is in the active state; when the key module 41 is not pressed, it is in the inactive state.

The control module 45 receives a judgment result from the capacitance detection module 43, and generates an input signal according to the working state of the key module 41. Specifically, when the input device 40 is a keyboard, the operator intends to input the letter A. When the key A is pressed, the capacitance value of the key module 41 corresponding to the key A becomes larger. Accordingly, the capacitance detection module 43 judges that the key module 41 is in the active state according to the capacitance change value. The control module 45 generates a control signal for inputting the letter A according to the active state of the key module 41, so as to realize the input operation of the letter A.

In the input device 40 described above, the key module 41 can be any one of the key module 10 disclosed in the first embodiment, the key module 20 disclosed in the second embodiment or the key module 30 disclosed in the third embodiment.

The input method of the input device 40 comprises the following steps:
S01, providing a pressing body of a key module 41 which is physically pressed by an external force, and the pressing body responding to the external physical pressing signal;
S02, providing a key switch, which is triggered to switch its working states between an on-state and an off-state in response to the physical pressing signal from the pressing body;
S03, providing a capacitor circuit arranged in series with that key switch, which adjusts a capacitance change magnitude of the key module 41 according to the working state of the key switch to generate a capacitance change signal;
S04, providing a capacitance detection module 43, which judges whether the working state of the key module 41 is active or not according to the capacitance change signal of the key module 41;
In step S05, providing a control module 45, which generates an input signal according to the active state of the key module 41.

Compared with the related art, in the input device 40 of the present application, a capacitor circuit is additionally arranged, and a branch is formed by the capacitor circuit and the key switch or by the capacitor circuit and the variable capacitor. Whether the pressing body is effectively pressed or not can be judged by judging the capacitance change value of the branch, so as to judge the working state of the key module. Based on this, the input signal of the input device is controlled. In this process, because the change of the key switch or the variable capacitor is triggered by the pressing body in response to an external physical pressing signal, the input device will not fail even if the key switch is in bad contact. The capacitor circuit can be set to selectively output different set capacitance values, thereby adjusting the capacitance change magnitude of the key module and improving the sensitivity of the key module. In addition, because the capacitance change value is relatively easy to be detected, the requirements on installation and on reliability of key switches are reduced, the reliability of products is improved, and the requirements on processing difficulty and assembly accuracy are reduced.

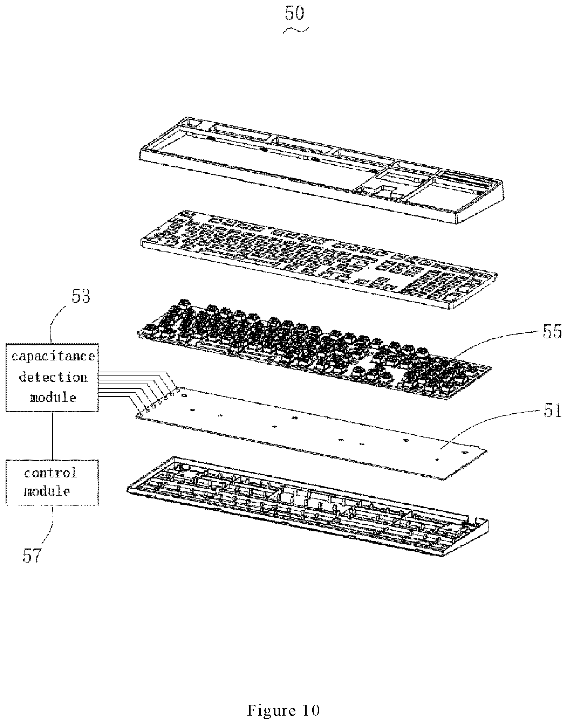

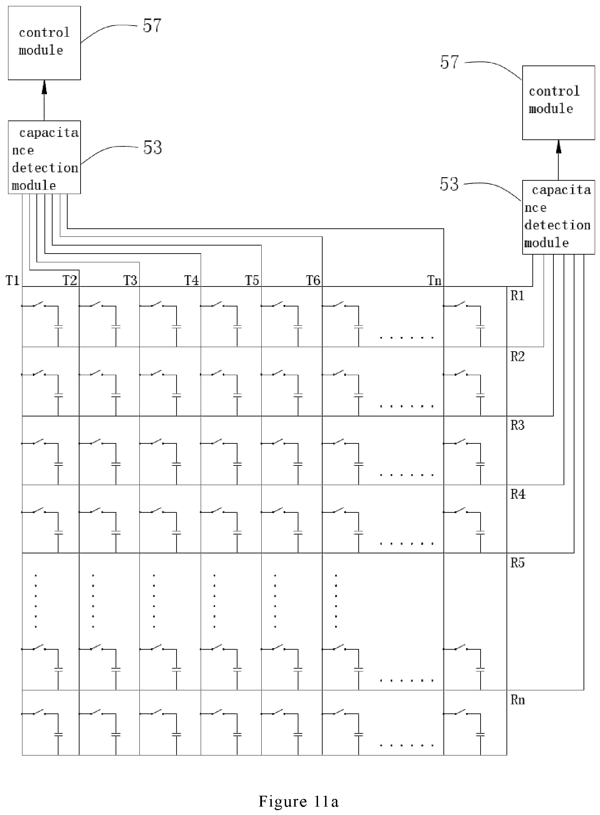

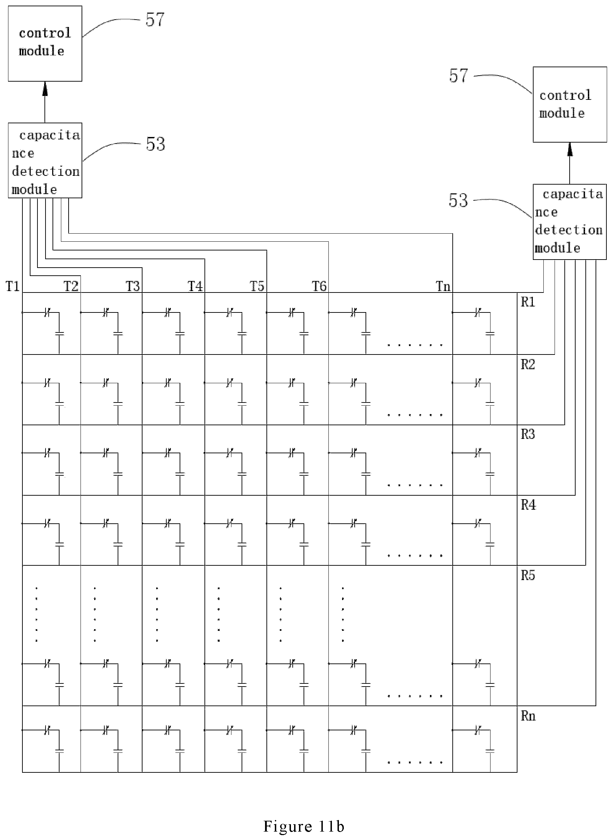

Please refer to Fig. 10, and Figs. 11a and 11b, wherein Fig. 10 is a schematic perspective structural view of a keyboard of the present application, and Figs. 11a and 11b are schematic structural diagrams of a circuit of the keyboard shown in Fig. 10, respectively. The keyboard 50 includes a control board 51, a capacitance detection module 53, a plurality of key modules 55 arranged in an array and a control module 57. The key modules 55 are arranged on the control board 51 in an array. The capacitance detection module 53 is arranged on the control board 51 and electrically connected with the key modules 55. The control module 57 correspondingly generates an input signal according to a detection result of the capacitance detection module 53. The key modules 55 include a circuit board, and as a further improvement, the control board 51 and the circuit board can be integrated into the same circuit board. The key module 55 can be any of the key modules 10, 20, 30 described above.

The above description is only for the purpose of illustrating embodiments of the present application and is not intended to limit the scope of the present application, and all modifications of equivalent structures and equivalent processes, which are made by the contents of the specification and the drawings of the present application or are directly or indirectly applied to other related technical fields, are also included in the scope of the present application.

## Claims

1. An input device, comprising:
a key module which receives a physical pressing signal and accordingly feeds back a capacitance change signal;
a capacitance detection module which receives the capacitance change signal from the key module and judges a working state of the key module;
a control module which receives a judgment result from the capacitance detection module and correspondingly generates an input signal, and is **characterized in that** the key module comprises a key switch and a capacitor circuit which are arranged in series, and the key module responds adjusts the change of the capacitance value of the key module in response to the external physical pressing signal.

2. The input device according to claim 1, **characterized in that** the capacitor circuit comprises a fixed capacitor or a plurality of fixed capacitors, wherein the fixed capacitors are connected in series or parallel to output a capacitance value, and cooperate with the key switch to output a capacitance change signal.

3. The input device according to claim 1, **characterized in that** the capacitor circuit includes multiple branches, each of the branches including at least one branch switch, wherein when the branch switch is turned on or off, the capacitor circuit outputs a corresponding set capacitance value, and the change of the capacitance value of the key module is adjusted.

4. The input device according to claim 1, **characterized in that** the key switch is a contact switch, and the key module further comprises a pressing body, wherein the pressing body moves down or up to switch the contact switch between an on-state and an off-state.

5. The input device according to claim 4, **characterized in that** the key switch comprises two conductive terminals, wherein the pressing body moves down or up so that the two conductive terminals are in contact conduction with each other, or separately disconnected.

6. The input device according to claim 1, **characterized in that** the key switch is an adjustable capacitor, and the adjustable capacitor is correspondingly arranged in series with the capacitor circuit.

7. The input device according to claim 6, **characterized in that** the adjustable capacitor comprises a first electrode piece and a second electrode piece which are coupled at a relative spacing, and are configured to adjust the capacitance value of the key module driven by the physical pressing signal.

8. The input device according to claim 7, wherein an insulating layer is arranged between the first electrode piece and the second electrode piece.

9. An input method using the input device according to any one of the input devices as claimed in claims 1 to 8, comprising the steps of:
providing a pressing body, which is physically pressed by an external force, wherein the pressing body responds to the external physical pressing signal;
providing a key switch which is triggered to switch its working state between an on-state and an off-state in response to the physical pressing signal from the pressing body;
providing a capacitor circuit arranged in series with that key switch, which adjusts a capacitance change magnitude of the key module according to the working state of the key switch to generate a capacitance change signal;
providing a capacitance detection module which can judge whether the working state of the key module is active or not according to the capacitance change signal of the key module;
providing a control module, which correspondingly generates an input signal according to the active state of the key module.

10. A keyboard, comprising a plurality of input devices and a control panel, wherein the input devices are arranged on the control panel in an array, **characterized in that** the input device is any one of the input devices as claimed in claims 1 to 8.
